# EUROPÄISCHE PATENTSCHRIFT

(11) **EP 3 281 506 B1**
(45) Veröffentlichungstag und Bekanntmachung des Hinweises auf die Patenterteilung: **04.12.2019**
(21) Anmeldenummer: 16724841.8
(22) Anmeldetag: 23.03.2016
(51) Int. Cl.: H05K 7/20, H05K 5/00

(54) **SCHALTSCHRANKANORDNUNG MIT EINER SCHALTSCHRANKREIHE UND EINEM DARIN EINGEREIHTEN KÜHLGERÄT**
ELECTRICAL ENCLOSURE ARRANGEMENT COMPRISING AN ELECTRICAL ENCLOSURE LINE AND A COOLING DEVICE CONNECTED INTO THE LINE
ENSEMBLE D'ARMOIRES ÉLECTRIQUES AVEC UNE RANGÉE D'ARMOIRES ÉLECTRIQUES ET UN APPAREIL DE REFROIDISSEMENT INTÉGRÉ DANS LA RANGÉE

(30) Priorität: 10.04.2015 DE 102015105493
(43) Veröffentlichungstag der Anmeldung: 14.02.2018
(73) Patentinhaber: Rittal GmbH & Co. KG, 35745 Herborn (DE)
(72) Erfinder: SCHREIER, Christoph, 35689 Leun (DE); EIBACH, Stefan, 35716 Dietzhölztal (DE); REITZ, Christoph, 35713 Eschenburg (DE); WAGNER, Steffen, 57299 Burbach (DE); VALLANI, Michele, 37067 Valeggio sul Minicio (VR) (IT)
(74) Vertreter: Angerhausen, Christoph
(86) Internationale Anmeldenummer: PCT/DE2016/100142
(87) Internationale Veröffentlichungsnummer: WO 2016/162014

(56) Entgegenhaltungen:
- WO-A2-2005/081091
- DE-A1-102012 110 247

## Beschreibung

Die Erfindung geht aus von einer Schaltschrankanordnung mit einer Schaltschrankreihe und einem darin eingereihten Kühlgerät, wobei die Schaltschrankreihe aus mehreren aneinander gereihten Schaltschränken gebildet ist, wobei das Kühlgerät über beide von zwei gegenüber liegende Seiten, über die es an jeweils einen der Schaltschränke angrenzt, Warmluft aus den Schaltschränken ansaugt und als gekühlte Luft zurück in die Schaltschränke bläst. Eine derartige Schaltschrankanordnung ist aus der WO 2005/081091 A2 bekannt. Ähnliche Schaltschrankanordnungen sind außerdem aus der DE 10 2012 110 247 A1, der DE 692 09 828 T2 sowie der DE 88 07 768 U1 bekannt.

Eine weitere Schaltschrankanordnung ist aus der DE 10 2012 007 707 A1 bekannt. Um bei aus dem Stand der Technik bekannten Schaltschrankanordnungen Schaltschränke, die über ein dazwischen angeordnetes Kühlgerät voneinander getrennt sind, über eine Stromsammelschiene elektrisch miteinander zu verbinden, ist es bisher erforderlich, die Stromsammelschiene außerhalb der Schaltschränke, beispielsweise oberhalb des Schaltschrankkorpus und über das dazwischen angeordnete Kühlgerät hinweg, zu führen. Dies erfordert jedoch einen erhöhten Platzbedarf und Installationsaufwand.

Es ist daher die Aufgabe der Erfindung, eine Schaltschrankanordnung der eingangs beschriebenen Art derart weiter zu entwickeln, dass sie die platzsparende Stromsammelschienenführung zwischen zwei Schaltschränken erlaubt, welche über ein in die Schaltschrankreihe eingereihtes Kühlgerät voneinander getrennt sind.

Zur Lösung dieser Aufgabe schlägt die Erfindung eine Schaltschrankanordnung mit den Merkmalen des Anspruchs 1 vor. Die abhängigen Ansprüche betreffen jeweils vorteilhafte Ausführungsformen der Erfindung.

Demgemäß wird vorgeschlagen, dass mindestens eine Sammelschiene zwischen den an das Kühlgerät angrenzenden Schaltschränken durch einen Sammelschienentransferraum des Kühlgeräts hindurch geführt ist, wobei der Sammelschienentransferraum über fluchtende Öffnungen in den beiden gegenüber liegenden Seiten zu den angrenzenden Schaltschränken hin geöffnet und die mindestens eine Sammelschiene durch die fluchtenden Öffnungen geführt ist, und wobei eine Warmluftansaugöffnung des Kühlgeräts in den Sammelschienentransferraum mündet, so dass Warmluft über die fluchtenden Öffnungen aus den angrenzenden Schaltschränken durch den Sammelschienentransferraum und die Warmluftansaugöffnung hindurch dem Kühlgerät zugeführt ist.

Das Kühlgerät soll auf keine bestimmten Gerätearten für die Erzeugung gekühlter Luft beschränkt ein. Das Kühlgerät kann beispielsweise ein mittels eines Lüfters durchströmter Luft-Kältemittel-Wärmetauscher sein, der über einen Vorlauf und einen Rücklauf mit einer externen Kältemittelquelle, beispielsweise einem Chiller, einem Rückkühler oder einer Kältemaschine, einen Kältemittelkreislauf bildet und von dieser mit gekühltem Kältemittel versorgt wird.

Es kann vorgesehen sein, dass das Kühlgerät ein Rahmengestell aus vier Vertikalstreben und acht Horizontalstreben aufweist, wobei innerhalb des von dem Rahmengestell umrissenen Montageraums ein Kühlgerätegehäuse, in dem mindestens ein Lüfter und ein Wärmeübertrager angeordnet sind, montiert ist, das an seiner Oberseite, über die das Kühlgerätegehäuse an den Sammelschienentransferraum grenzt, eine Warmluftansaugöffnung aufweist, und wobei Warmluft von dem mindestens einen Lüfter über die Warmluftansaugöffnung angesogen, durch den Wärmeübertrager geleitet und über Kühlluftausblasöffnungen ausgeblasen wird.

Weiterhin kann das Kühlgerätegehäuse an zwei parallel zueinander und senkrecht zu der Oberseite angeordneten Seitenelementen jeweils eine der Kühlluftausblasöffnungen aufweisen, die jeweils in einen der angrenzenden Schaltschränke münden. Dabei kann der Sammelschienentransferraum derjenige Abschnitt des Montageraums des Kühlgeräterahmengestells sein, der oberhalb von der Oberseite des Kühlgerätegehäuses angeordnet ist.

Ebenso können die angrenzenden Schaltschränke jeweils ein weiteres Rahmengestell aus vier Vertikalstreben und acht Horizontalstreben aufweisen, wobei die Vertikalstreben und die Tie fenstreben der drei Rahmengestelle gleich lang bemessen sind, und wobei das Rahmengestell des Kühlgeräts an den zwei gegenüberliegenden Seiten des Kühlgeräts mit dem Rahmengestell des jeweils angrenzenden Schaltschranks verbunden ist, so dass die Innenräume der Schaltschränke über den Sammelschienentransferraum fluidisch miteinander verbunden sind.

Es kann weiterhin vorgesehen sein, dass unmittelbar unterhalt von der Oberseite des Kühlgerätegehäuses ein Installationsraum ausgebildet ist, in dem zumindest ein elektrisches Steuer- und Regelgerät für den Betrieb des Kühlgeräts, beispielsweise ein Inverter, angeordnet ist. Dabei kann die Oberseite als eine abnehmbare und luftdurchlässige Abdeckung ausgebildet sein, insbesondere als ein rechteckiger Gitterrahmen, der an seinen vier Ecken mit jeweils einer der vier Vertikalstreben des Rahmengestells des Kühlgeräts verbunden ist.

Schließlich kann die Warmluftansaugöffnung in der Oberseite des Kühlgerätegehäuses über den Installationsraum mit einem Lufteinlass des Wärmeübertrages fluidisch in Verbindung stehen, so dass die angesogene Luft den Installationsraum durchströmt und von dem elektrischen Steuer- und Regelgerät erzeugte Abwärme abführt.

Weitere Einzelheiten der Erfindung werden anhand der nachstehenden Figuren erläutert. Dabei zeigt:
- Figur 1: in perspektivischer Darstellung eine Ausführungsform des erfindungsgemäßen Kühlgeräts;
- Figur 2: in perspektivischer Darstellung eine Ausführungsform der erfindungsgemäßen Schaltschrankanordnung; und
- Figur 3: eine schematische Darstellung der sich in der Schaltschrankanordnung nach Figur 2 ausbildenden Luftströmung.

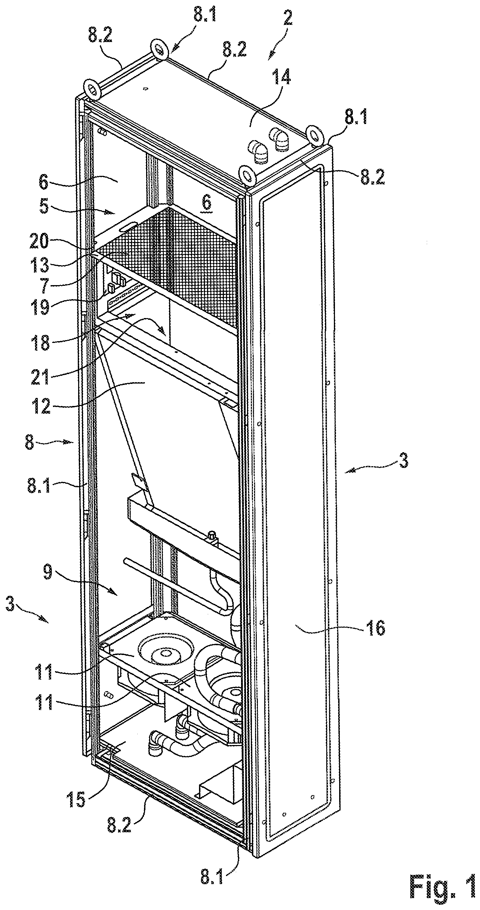

Das in Figur 1 gezeigte Kühlgerät 2 weist ein Rahmengestell 8 mit Vertikalstreben 8.1 und Horizontalstreben 8.2 auf, die einen quaderförmigen Montagekorpus bilden und eine Systemlochung aufweisen, über die die für das Kühlgerät 2 wesentlichen Komponenten im Inneren des Rahmengestells 8 montiert sind. Die Geometrie der Profilschienen 8.1 und 8.2 kann beispielsweise der eines gängigen Rahmenprofils entsprechen, wie es aus dem Schaltschrankbau, beispielsweise aus der DE 196 47 723 C1, bekannt ist.

In einem unteren Bereich des Montageraums 9 ist eine Anordnung von zwei Lüftern 11 ausgebildet, über die die zu kühlende Luft über eine Warmluftansaugöffnung 7 durch den Wärmeübertrager 12 hindurch transportiert und als gekühlte Luft über die Kühlluftausblasöffnung 15 in den Schaltschrank (nicht dargestellt) zurück ausgeblasen wird. Die Warmluftansaugöffnung 7 begrenzt einen Sammelschienentransferraum 5, der sich zwischen gegenüber liegenden Seiten 3 des Kühlgeräts 2 durchgängig erstreckt, nach unten, während der Sammelschienentransferraum 5 nach oben über ein Dachelement des Kühlgeräts 2 begrenzt ist. Die Warmluftansaugöffnung 7 ist in einer Oberseite des Kühlgerätegehäuses 10 ausgebildet und ist ein abnehmbarer Gitterrahmen, der einen Installationsraum 18 von dem Sammelschienentransferraum 5 abgrenzt. Der Installationsraum 18 ist gerade zwischen dem Wärmeübertrager 12 und der Oberseite 13 des Gehäuses 10 ausgebildet und dient zur Aufnahme eines elektrischen Steuer- und Regelgeräts 19 für den Betrieb des Kühlgeräts 2, beispielsweise eines Inverters, so dass das Steuer- und Regelgerät 19 einerseits vor ungewolltem Zugriff geschützt untergebracht, andererseits, beispielsweise im Wartungsfall, durch Entfernen der Oberseite 13 leicht zugänglich ist.

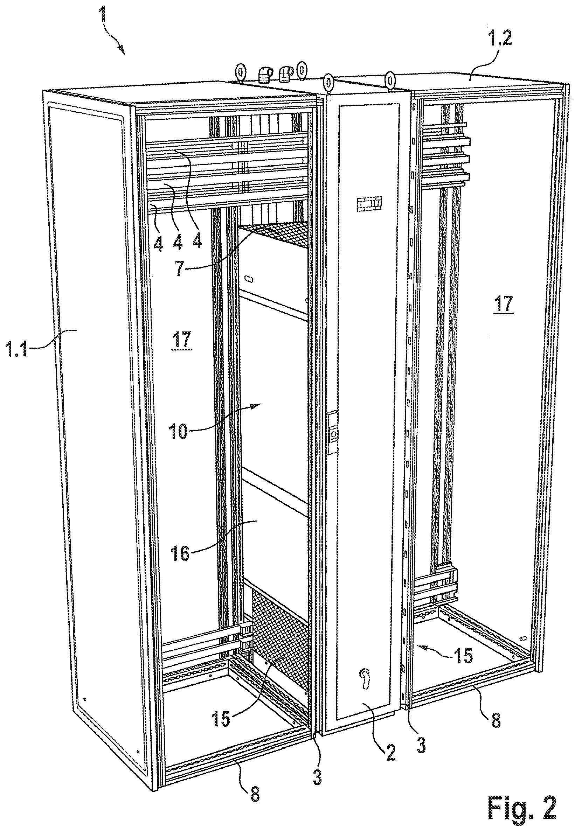

In Figur 2 ist eine Ausführungsform der Schaltschrankanordnung in perspektivischer Darstellung gezeigt. Es ist insbesondere zu erkennen, dass es die dargestellte Schaltschrankordnung erlaubt, dass die Sammelschienen 4 von dem in der Darstellung linken Schaltschrank 1.1 durch das Kühlgerät 2, nämlich durch den Sammelschienentransferraum 5 hindurch bis in den in der Darstellung rechten Schaltschrank 1.2 ohne Unterbrechung durchgeführt werden können. Das Gehäuse 10 des Kühlgeräts 2 erstreckt sich in Vertikalrichtung gerade bis zu der Warmluftansaugöffnung 7, die in den Sammelschienentransferraum 5 mündet. Am unteren Ende der Seitenelemente 16 des Gehäuses 10 des Kühlgerätes 2 ist jeweils eine Kühlluftausblasöffnung 15 ausgebildet, die in einem unteren Bereich im Innenraum 17 des linken Schaltschranks 1.1 bzw. in den Innenraum 17 des rechten Schaltschranks 1.2 mündet.

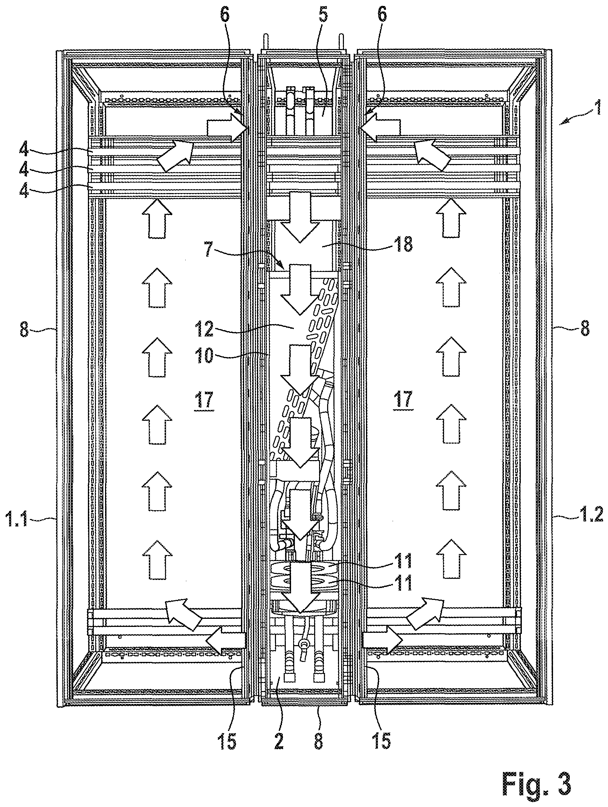

In Figur 3 ist der sich ergebende Luftvolumenstrom veranschaulicht. Die erwärmte Luft in den Innenräumen 17 der Schaltschränke 1.1, 1.2 tritt über die fluchtenden, seitlichen Öffnungen 6, über die der Sammelschienentransferraum 5 in die Innenräume 17 mündet, in den Sammelschienentransferraum 5 ein, um von dort durch die Warmluftansaugöffnung 7 des Gehäuses 10 des Kühlgerätes 2 in das Kühlgerät 2 einzutreten. Nachdem die zu kühlende Luft den Wärmeübertrager 12 durchsetzt und Wärmeenergie abgetauscht hat, wird sie von den Lüftern 11 als gekühlte Luft über die unteren seitlichen Kühlluftausblasöffnungen 15 in den Seitenwänden 16 (siehe Figuren 1 und 2) des Gehäuses 10 zurück in die Innenräume 17 der Schaltschränke 1.1, 1.2 geleitet. Es ergibt sich so der durch die Pfeile veranschaulichte Luftvolumenstrom.

Die Figur 3 zeigt weiterhin, dass die Rahmengestelle der beiden Schaltschränke 1.1. und 1.2 in ihren Vertikal- und Tiefenabmessungen identisch ausgebildet sind, so dass sich eine einfache Anreihung über die Rahmengestelle von Schaltschränken 1.1, 1.2. und Kühlgerät 2 ergibt. Dies kann mit Hilfe der aus dem Stand der Technik für die Schaltschrankanreihung bekannten Verbindungsmittel erfolgen. Beispielsweise können auch zwischen den aneinander grenzenden Vertikal- und Horizontalstreben der Rahmengestelle 8 Dichtelemente ausgebildet sein, um eine fluidisch dichte Verbindung zwischen dem Kühlgerät 2 und dem jeweiligen Schaltschrank 1.1 und 1.2 herzustellen.

### Bezugszeichenliste

- 1: Schaltschrankreihe
- 1.1, 1.2: Schaltschrank
- 2: Kühl gerät
- 3: Seite
- 4: Sammelschiene
- 5: Sammelschienentransferraum
- 6: Öffnung
- 7: Warmluftansaugöffnung
- 8: Rahmengestell
- 8.1: Vertikalstrebe
- 8.2: Horizontalstrebe
- 9: Montageraum
- 10: Kühlgerätegehäuse
- 11: Lüfter
- 12: Wärmeübertrager
- 13: Oberseite
- 14: Dachelement
- 15: Kühlluftausblasöffnung
- 16: Seitenelement
- 17: Innenraum
- 18: Installationsraum
- 19: Steuer- und Regelgerät
- 20: Ecke
- 21: Lufteinlass

## Patentansprüche

1. Schaltschrankanordnung mit einer Schaltschrankreihe (1) und einem darin eingereihten Kühlgerät (2), wobei die Schaltschrankreihe (1) aus mehreren aneinander gereihten Schaltschränken (1.1, 1.2) gebildet ist, wobei das Kühlgerät (2) über beide von zwei gegenüber liegende Seiten (3), über die es an jeweils einen der Schaltschränke (1.1, 1.2) angrenzt, Warmluft aus den Schaltschränken (1.1, 1.2) ansaugt und als gekühlte Luft zurück in die Schaltschränke (1.1, 1.2) bläst, **dadurch gekennzeichnet, dass** mindestens eine Sammelschiene (4) zwischen den an das Kühlgerät (2) angrenzenden Schaltschränken (1.1, 1.2) durch einen Sammelschienentransferraum (5) des Kühlgeräts (2) hindurch geführt ist, wobei der Sammelschienentransferraum (5) über fluchtende Öffnungen (6) in den beiden gegenüber liegenden Seiten (3) zu den angrenzenden Schaltschränken (1.1, 1.2) hin geöffnet und die mindestens eine Sammelschiene (4) durch die fluchtenden Öffnungen (6) geführt ist, und wobei eine Warmluftansaugöffnung (7) des Kühlgeräts (2) in den Sammelschienentransferraum (5) mündet, so dass Warmluft über die fluchtenden Öffnungen (6) aus den angrenzenden Schaltschränken (1.1, 1.2) durch den Sammelschienentransferraum (5) und die Warmluftansaugöffnung (7) hindurch dem Kühlgerät (2) zugeführt ist.

2. Schaltschrankanordnung nach Anspruch 1, bei der das Kühlgerät (2) ein Rahmengestell (8) aus vier Vertikalstreben (8.1) und acht Horizontalstreben (8.2) aufweist, wobei innerhalb des von dem Rahmengestell (8) umrissenen Montageraums (9) ein Kühlgerätegehäuse (10), in dem mindestens ein Lüfter (11) und mindestens ein Wärmeübertrager (12) angeordnet sind, montiert ist, das an seiner Oberseite (13), über die das Kühlgerätegehäuse (10) an den Sammelschienentransferraum (5) grenzt, eine Warmluftansaugöffnung (7) aufweist, und wobei Warmluft von dem mindestens einen Lüfter (11) über die Warmluftansaugöffnung (7) angesogen, durch den Wärmeübertrager (12) geleitet und über Kühlluftausblasöffnungen (15) ausgeblasen ist.

3. Schaltschrankanordnung nach Anspruch 2, bei der das Kühlgerätegehäuse (10) an zwei parallel zueinander und senkrecht zu der Oberseite (13) angeordneten Seitenelementen (16) jeweils eine der Kühlluftausblasöffnung (15) aufweist, die jeweils in einen der angrenzenden Schaltschränke (1.1, 1.2) münden.

4. Schaltschrankanordnung nach Anspruch 2 oder 3, bei der der Sammelschienentransferraum (5) derjenige Abschnitt des Montageraums (9) des Kühlgeräterahmengestells (8) ist, der oberhalb von der Oberseite (13) des Kühlgerätegehäuses (10) angeordnet ist.

5. Schaltschrankanordnung nach einem Ansprüche 2 bis 4, bei der die angrenzenden Schaltschränke (1.1, 1.2) jeweils ein weiteres Rahmengestell (8) aus vier Vertikalstreben (8.1) und acht Horizontalstreben (8.2) aufweisen, wobei die Vertikalstreben (8.1) und die Tiefenstreben der drei Rahmengestelle (8) gleich lang bemessen sind und wobei das Rahmengestell (8) des Kühlgeräts (1) an den zwei gegenüberliegenden Seiten (3) des Kühlgeräts (2) mit dem Rahmengestell (8) des jeweils angrenzenden Schaltschranks (1.1, 1.2) verbunden ist, so dass die Innenräume (17) der Schaltschränke (1.1, 1.2) über den Sammelschienentransferraum (5) fluidisch miteinander verbunden sind.

6. Schaltschrankanordnung nach einem Ansprüche 2 bis 5, bei der unmittelbar unterhalb von der Oberseite (13) des Kühlgerätegehäuses (10) ein Installationsraum (18) ausgebildet ist, in dem zumindest ein elektrisches Steuer- und Regelgerät (19) für den Betrieb des Kühlgeräts (2) angeordnet ist.

7. Schaltschrankanordnung nach Anspruch 6, bei der die Oberseite (13) als eine abnehmbare und luftdurchlässige Abdeckung ausgebildet ist, insbesondere als ein rechteckiger Gitterrahmen, der an seinen vier Ecken (20) mit jeweils einer der Vertikalstreben (8.1) des Rahmengestells (8) des Kühlgeräts (2) verbunden ist.

8. Schaltschrankanordnung nach Anspruch 6 oder 7, bei der die Warmluftansaugöffnung (7) in der Oberseite (13) des Kühlgerätegehäuses (10) über den Installationsraum (18) mit einem Lufteinlass (21) des Wärmeübertragers (12) fluidisch in Verbindung steht, so dass die angesogene Luft den Installationsraum (18) durchströmt und von dem elektrischen Steuer- und Regelgerät (19) erzeugte Abwärme abführt.

## Claims

1. A switch cabinet arrangement with a switch cabinet row and a cooling device (2) arranged therein, wherein the switch cabinet row (1) is formed from multiple of lined-up switch cabinets (1.1, 1.2), wherein the cooling device (2) via both of two opposite faces (3), via which it adjoins respectively one of the switch cabinets (1.1, 1.2), suctions hot air from the switch cabinets (1.1, 1.2) and blows it back into the switch cabinets (1.1, 1.2) as cooled air, **characterized in that** at least one busbar (4) is guided between the switch cabinets (1.1, 1.2) adjoining the cooling device (2), through a busbar transfer area (5) of the cooling device (2), wherein the busbar transfer area (5) is opened via aligned openings (6) in the two opposite faces (3) to the adjoining switch cabinets (1.1, 1.2) and the at least one busbar (4) is directed through the aligned openings (6), and wherein a hot air intake opening (7) of the cooling device (2) opens into the busbar transfer area (5), so that hot air is directed via the aligned openings (6) from the adjoining switch cabinets (1.1, 1.2) through the busbar transfer area (5) and through the hot air intake opening (7) to the cooling device (2).

2. The switch cabinet arrangement of claim 1, in which the cooling device (2) has a rack (8) with four vertical struts (8.1) and eight horizontal struts (8.2), wherein within the installation space (9) enclosed by the rack (8) a cooling device housing (10) is mounted, in which at least one fan (11) and at least one heat transfer device (12) are arranged, which on its upper side (13), via which the cooling device housing (10) adjoins the busbar transfer area (5), has a hot air intake opening (7), and wherein hot air is suctioned from the at least one fan (11) via the hot air suction opening (7), guided through the heat transfer device (12), and blown out via cool air blowout openings (15).

3. The switch cabinet arrangement of claim 2, in which the cooling device housing (10) has on two side elements (16) that are parallel to each other and perpendicularly arranged to the upper side (13) a respective cooling air blowout opening (15), which each open in one of the adjoining switch cabinets (1.1, 1.2).

4. The switch cabinet arrangement of claim 2 or 3, in which the busbar transfer area (5) is that section of the installation space (9) of the cooling device rack (8), which is arranged above the upper side (13) of the cooling device housing (10).

5. The switch cabinet arrangement of any of claims 2 to 4, in which the adjoining switch cabinets (1.1, 1.2) each have an additional rack (8) with four vertical struts (8.1) and eight horizontal struts (8.2), the vertical struts (8.1) and the depth struts of the three racks (8) being dimensioned to be equally long and with the rack (8) of the cooling device (1) on the two opposite faces (3) of the cooling device (2) being connected with the rack (8) of the respective adjoining switch cabinet (1.1, 1.2) so that the interior spaces (17) of the switch cabinets (1.1, 1.2) are fluidically connected with each other via the busbar transfer area (5).

6. The switch cabinet arrangement of any of claims 2 to 5, in which directly below the upper side (13) of the cooling device housing (10) an installation space (18) is formed, in which at least one electrical control and regulation device (19) is arranged for operation of the cooling device (2).

7. The switch cabinet arrangement of claim 6, in which the upper side (13) is formed as a removable and air-permeable covering, particularly as a rectangular grid frame, which on each of its four corners (20) is connected with one of the vertical struts (8.1) of the rack (8) of the cooling device (2).

8. The switch cabinet arrangement of claims 6 or 7, in which the hot air intake opening (7) in the upper side (13) of the cooling device housing (10) is in fluidic connection via the installation space (18) with an air inlet (21) of the heat transfer device (12), so that the suctioned air flows through the installation space (18) and expels waste heat generated by the electrical control and regulation device (19).

## Revendications

1. Disposition d'armoire de commande avec une série d'armoires de commande (1) et un appareil de refroidissement (2) intégré à l'intérieur, la série d'armoires de commande (1) étant constituée de plusieurs armoires de commande (1.1, 1.2) juxtaposées, l'appareil de refroidissement (2) aspirant, par l'intermédiaire des deux côtés opposés (3), par l'intermédiaire de chacun desquels il est adjacent à une des armoires de commande (1.1, 1.2), de l'air chaud provenant des armoires de commande (1.1, 1.2) et le soufflant sous forme d'air froid à nouveau dans les armoires de commande (1.1, 1.2), **caractérisée en ce qu'**au moins un rail collecteur (4) est guidé, entre les armoires de commande (1.1, 1.2) adjacentes à l'appareil de refroidissement (2), à travers un espace de transfert de rail collecteur (5) de l'appareil de refroidissement (2), l'espace de transfert de rail collecteur (5) étant ouvert, par l'intermédiaire d'ouvertures alignées (6) dans les deux côtés opposés (3), en direction des armoires de commande (1.1, 1.2) adjacentes et l'au moins un rail collecteur (4) étant guidé à travers les ouvertures alignées (6), et une ouverture d'aspiration d'air chaud (7) de l'appareil de refroidissement (2) débouchant dans l'espace de transfert du rail collecteur (5), de façon à ce que l'air chaud soit introduit, par l'intermédiaire des ouvertures alignées (6), à partir des armoires de commande (1.1, 1.2) adjacentes, à travers l'espace de transfert du rail collecteur (5) et l'ouverture d'aspiration d'air chaud (7), dans l'appareil de refroidissement (2).

2. Disposition d'armoire de commande selon la revendication 1, dans laquelle l'appareil de refroidissement (2) comprend un châssis (8) constitué de quatre entretoises verticales (8.1) et de huit entretoises horizontales (8.2), moyennant quoi, à l'intérieur de l'espace de montage (9) délimité par le châssis (8), est monté un boîtier d'appareil de refroidissement (10), dans lequel sont disposés au moins un ventilateur (11) et au moins un échangeur thermique (12), qui comprend, sur son côté supérieur (13), par l'intermédiaire duquel le boîtier d'appareil de refroidissement (10) est adjacent à l'espace de transfert du rail collecteur (5), une ouverture d'aspiration d'air chaud (7) et l'air chaud étant aspiré par l'au moins un ventilateur (11) par l'intermédiaire de l'ouverture d'aspiration d'air chaud (7), conduit à travers l'échangeur thermique (12) et expulsé par l'intermédiaire d'ouvertures d'expulsion d'air de refroidissement (15).

3. Disposition d'armoire de commande selon la revendication 2, dans laquelle le boîtier d'appareil de refroidissement (10) comprend, au niveau de chacun des éléments latéraux (16) disposés parallèlement entre eux et perpendiculairement au côté supérieur (13), une des ouvertures d'expulsion d'air de refroidissement (15) qui débouchent chacune dans une des armoires de commande (1.1, 1.2) adjacentes.

4. Disposition d'armoire de commande selon la revendication 2 ou 3, dans laquelle l'espace de transfert du rail collecteur (5) est la portion de l'espace de montage (9) du châssis de l'appareil de refroidissement (8) qui est disposée au-dessus du côté supérieur (13) du boîtier d'appareil de refroidissement (10).

5. Disposition d'armoire de commande selon l'une des revendications 2 à 4, dans laquelle les armoires de commande (1.1, 1.2) adjacentes comprennent chacune un autre châssis (8) constitué de quatre entretoises verticales (8.1) et de huit entretoises horizontales (8.2), les entretoises verticales (8.1) et les entretoises de profondeur des trois châssis (8) présentant la même longueur et le châssis (8) de l'appareil de refroidissement (1) étant relié, au niveau des deux côtés opposés (3) de l'appareil de refroidissement (2), avec le châssis (8) de l'armoire de commande (1.1, 1.2) respectivement adjacente, de façon à ce que les espaces internes (17) des armoires de commande (1.1, 1.2) soient reliés entre eux de manière fluidique par l'intermédiaire de l'espace de transfert du rail collecteur (5).

6. Disposition d'armoire de commande selon l'une des revendications 2 à 5, dans laquelle, directement en dessous du côté supérieur (13) du boîtier d'appareil de refroidissement (10), est formé un espace d'installation (18) dans lequel est disposé un appareil de contrôle et de régulation électrique (19) pour le fonctionnement de l'appareil de refroidissement (2).

7. Disposition d'armoire de commande selon la revendication 6, dans laquelle le côté supérieur (13) est conçu comme un recouvrement amovible et perméable à l'air, plus particulièrement comme un cadre à grille rectangulaire, qui est relié, au niveau de chacun de ses quatre angles (20), avec une des entretoises verticales (8.1) du châssis (8) de l'appareil de refroidissement (2).

8. Disposition d'armoire de commande selon la revendication 6 ou 7, dans laquelle l'ouverture d'aspiration d'air chaud (7) est reliée de manière fluidique, sur le côté supérieur (13) du boîtier de l'appareil de refroidissement (10) au-dessus de l'espace d'installation (18), avec une entrée d'air (21) de l'échangeur thermique (12), de façon à ce que l'air aspiré traverse l'espace d'installation (18) et évacue la chaleur générée par l'appareil de contrôle et de régulation (19).
